# EUROPEAN PATENT APPLICATION

(11) **EP 1 154 322 A1**
(43) Date of publication of application: **14.11.2001**
(21) Application number: 00126271.6
(22) Date of filing: 01.12.2000
(51) Int. Cl.: G03F 7/038, G03F 7/18

(54) **Flexographic printing cylinders and sleeves with cylindrical, seamless photopolymer printing layer, photopolymer composition therefor, and method of making said cylinders and sleeves from said composition.**

(30) Priority: 10.05.2000 US 202552
(71) Applicant: ERMINIO ROSSINI S.P.A., I-20027 Rescaldina Milan (IT)
(72) Inventor: Rossini, Felice, 20121 Milano (IT); Nazzaro, Alfonso C., Rochester, New York 14624 (US)
(74) Representative: Ripamonti, Enrico, Dr. Ing.

(57) **Abstract**

A liquid photopolymer composition having a predefined viscosity in the range of 25 to 35 centipoises such that it can be sprayed onto a rotating cylindrical core to form a seamless, cylindrical surface in the range of 60 to 70 Shore A hardness suitable for imaging the printing matrices of a flexographic printing sleeve, the composition comprising:
a photopolymer of Shore D hardness in the range of 50 to 70;
a carrier solvent;
a grafted monomer to reduce the hardness to a range of 60 to 70 Shore A; and
at least one of the following materials: monomers, photoinitiators, and photosensitizers.

## Description

The present invention relates to flexographic photopolymer printing sleeves and cylinders and more particularly to such sleeves and cylinders with a seamless photopolymer layer.

One method of forming the image on a flexographic printing plate involves the following. A virgin, non-cured sheet of photopolymer that is sensitive to ultraviolet light (or actinic light) is laid on a transparent substrate such as a glass plate. A negative is placed on top of the photopolymer sheet. Ultraviolet light (or actinic light) is shined on the photopolymer sheet from beneath the glass plate and from above the top of the photopolymer sheet where the negative has been placed. The ultraviolet light (or actinic light) cures (hardens) the underside of the photopolymer sheet and the portions of the top of the sheet that were left unexposed by the negative. The duration of the exposure of the sheet's underside to the ultraviolet light (or actinic light) shining beneath the glass plate depends upon the sheet's thickness. While the duration of the exposure of the top of the sheet to the ultraviolet light (or actinic light) depends upon the depth of the image relief required, which is also referred to as the depth of the sheet's floor from the surfaces that receive and transfer the ink to the printing surface. The polymerized sheet is transferred into a solvent bath and scrubbed to remove the unpolymerized (unhardened) portions of the sheet that were not exposed to the actinic ultraviolet light and so were left unpolymerized. Upon removal of the sheet from the solvent bath, the top side of the sheet is left with an image defined by raised surfaces that can receive ink and apply the image to be printed by the printing plate.

As is conventional, sticky backs (double-sided adhesive tapes) are attached to the underside of the sheet bearing the image, and the sheet is then wound around a printing sleeve or cylinder with the underside of the sheet attached to the exterior cylindrical surface of the printing sleeve or cylinder. In such a conventional printing plate, there is always a gap where the opposite edges of the imaged sheet come together.

Increasingly, printing jobs require images that are continuous. Examples of such jobs would include gift wrap, wall paper or flexible packaging requiring a continuous image. To satisfy this requirement, the image on the printing sleeve or printing cylinder must be continuous. Continuous images can only be formed in a printing surface that is continuous and seamless. Accordingly, printing sleeves (or printing cylinders) that carry printing plates with gaps or seams are unacceptable.

Rolls or sleeves covered with rubber are continuous and seamless and can be engraved by lasers controlled by digital positioning technology in order to remove rubber from designated sections to leave a raised image on the rubber that can receive ink and produce the desired continuous image. However, such digitally imaged rubber rolls or sleeves are expensive. Moreover, the maximum resolution obtainable with a photopolymer sleeve is about 200 to 220 dots per linear inch, while the maximum resolution obtainable with digitally imaged rubber rolls or sleeves is only about 120 to 135 dots per linear inch. Thus, digitally imaged rubber rolls or sleeves cannot achieve images with resolutions as high as the resolution obtainable with a photopolymer covered sleeve.

Typically, photopolymer plates cannot be engraved directly using lasers because the laser will burn the photopolymer. However, another way of forming an image on a plate involves a digital photopolymer plate that has been wound around and attached to a printing sleeve or printing cylinder by sticky backs. Such photopolymer plates have trade names such as NYLOFLEX® , CYREL® and KOR POLYFIRBRON® and typically have durometers in the range of 45 to 50 Shore A. The exposed surface of the plate is then coated with a mask layer of carbon black material. An Yttrium-Aluminum-Garnet (YAG) laser, which is a particular kind of laser that is sensitive to black color, can be used to ablate the black masked material and so define the desired image where the black mask has been ablated by the laser. Ultraviolet light can then be applied to the rotating sleeve or cylinder to form what is known as a digital photopolymer plate. This digitally imaged photopolymer plate is then placed in a solvent bath and scrubbed to remove the unpolymerized (unexposed) areas beneath the black mask to create a relief image. Then the imaged plate is post-cured with UV light to cure and harden the unexposed areas (such as the floor) of the plate. The raised image will then be capable of receiving ink and producing the desired printed image. As in the prior case, there is always a gap where the opposite edges of the imaged digital photopolymer plate come together.

To eliminate the gap, before the image is to be formed, the attached sheet of photopolymer is wrapped around the sleeve or cylinder so that the ends of the sheet butt together to form a seam. To produce a seamless photopolymer layer that is wrapped around a sleeve or cylinder, the sleeve or cylinder carrying the butting ends of the wrapped photopolymer sheet is subjected to high temperatures on the order of 250 degrees Fahrenheit by baking in an oven until the butting ends have become fused together. Upon removal from the high temperature treatment, which is an expensive and time consuming process, it is necessary to grind and polish the fused structure until it is smooth and in round with the rest of the sleeve or cylinder. These are known as LASER SEAMEX® photopolymer sleeves, but are very costly. After such LASER SEAMEX® photopolymer sleeves are ground and polished, the exposed surface of the sleeve is then ready to be imaged as described above using a mask layer of carbon black material and an YAG laser to define the desired image.

It is a principal object of the present invention to provide a flexographic seamless, cylindrical layer of photopolymer that is formed on an underlying cylindrical substrate, whether in a sleeve structure or cylinder, at less cost than by conventional methods and wherein the layer can be processed to form the printing surface of a flexographic printing sleeve or cylinder using conventional equipment and processing techniques.

It is a further principal object of the present invention to provide a seamless, continuous, cylindrical photopolymer layer that eliminates the need for adhesives or sticky backs to adhere the photopolymer layer to the flexographic cylinder or sleeve.

It is another principal object of the present invention to provide a method for producing a flexographic printing sleeve or cylinder having a printing surface formed in a seamless, cylindrical layer of photopolymer of uniform thickness.

An additional principal object of the present invention is to provide a method of applying a seamless, cylindrical layer of photopolymer of uniform thickness onto a cylindrical flexographic printing sleeve or cylinder that can be digitally imaged and processed in order to produce a raised surface to carry the ink that is to be applied in a printing process.

It also is a principal object of the present invention to provide a method of spraying a liquid composition of photopolymer onto a cylindrical substrate to form a seamless, continuous, uniformly thick, cylindrical photopolymer layer that can be ground/polished and digitally imaged and processed to form the printing surface of a flexographic printing sleeve or cylinder.

It is also another principal object of the present invention to provide a method of spraying a liquid composition of photopolymer onto a cylindrical substrate to form a seamless, continuous, uniformly thick, cylindrical photopolymer layer with a surface that does not need to be ground/polished before it can receive a carbon black film prior to being digitally imaged and processed to form the printing surface of a flexographic printing sleeve or cylinder.

It is a yet further principal object of the present invention to provide a liquid composition of photopolymer that can be sprayed onto a cylindrical substrate to form a seamless, continuous, uniformly thick, cylindrical photopolymer layer that can be processed to form the printing surface of a flexographic printing sleeve or cylinder.

It is still another principal object of the present invention to provide a liquid composition of photopolymer that can be sprayed onto a cylindrical substrate to form a seamless, continuous, uniformly thick, cylindrical photopolymer layer that has a hardness measured by a durometer in the range of 60 to 70 Shore A and can be processed to form the printing surface of a flexographic printing sleeve or cylinder.

It is yet another principal object of the present invention to graft monomers to photopolymers of 40 to 70 Shore D hardness in order to reduce the hardness thereof and provide a liquid composition of photopolymer of 60 to 70 Shore A hardness that can be sprayed onto a cylindrical substrate to form a seamless, continuous, uniformly thick, cylindrical photopolymer layer that can be processed to form the printing surface of a flexographic printing sleeve or cylinder.

It is a further principal object of the present invention to provide a flexographic printing sleeve or cylinder that carries the printing surface on a seamless, continuous, uniformly thick, cylindrical photopolymer layer formed by one of the foregoing methods.

Additional objects and advantages of the invention will be set forth in part in the description which follows, and in part will be obvious from the description, or may be learned by practice of the invention. The objects and advantages of the invention may be realized and attained by means of the instrumentalities and combinations particularly pointed out in the appended claims.

To achieve the objects and in accordance with the purpose of the invention, as embodied and broadly described herein, a method is provided of spraying a composition of liquified photopolymer onto a cylindrical core to produce a seamless and continuous cylindrical layer of photopolymer that can be imaged to form the printing surface of a flexographic printing sleeve and/or cylinder. The sprayable photopolymer composition can be formed from photopolymer sheets of 50 to 70 Shore D hardness that are absorbed into a solvent and mixed with monomers to produce a liquid that can be sprayed onto a cylindrical core and form a photopolymer layer of 60 to 70 Shore A hardness. The sprayable photopolymer composition also includes photoinitiators and photosensitizers. Desirably, the cylindrical core is a fiberglass core that is sufficiently flexible to function as the inner cylindrical core of a flexographic printing sleeve that can be air mounted and dismounted from the mandrel of a flexographic printing machine.

The accompanying drawings, which are incorporated in and constitute a part of this specification, illustrate one embodiment of the invention and, together with the description, serve to explain the principles of the invention.
Fig. 1 is a schematic representation of a presently preferred embodiment of the method of the present invention;
Figs. 2 and 3 are schematic representations of components found in Fig. 1 and/or used in performing additional steps of the process;
Fig. 4 is a schematic representation of an elevated perspective view of a flexographic printing sleeve according to the present invention mounted on an air-pressurized mandrel for a flexographic printing machine;
Fig. 5 is a schematic representation of an elevated perspective view of a flexographic printing cylinder according to the present invention; and
Fig. 6A - 6E are schematic representations of sections of flexographic printing sleeves and/or cylinders formed according to the method of the present invention.

Reference now will be made in detail to the presently preferred embodiments of the invention, one or more examples of which are illustrated in the accompanying drawings. Each example is provided by way of explanation of the invention, not limitation of the invention. In fact, it will be apparent to those skilled in the art that various modifications and variations can be made in the present invention without departing from the scope or spirit of the invention. For instance, features illustrated or described as part of one embodiment, can be used on another embodiment to yield a still further embodiment. Thus, it is intended that the present invention cover such modifications and variations as come within the scope of the appended claims and their equivalents. The same numerals are assigned to the same components throughout the drawings and description.

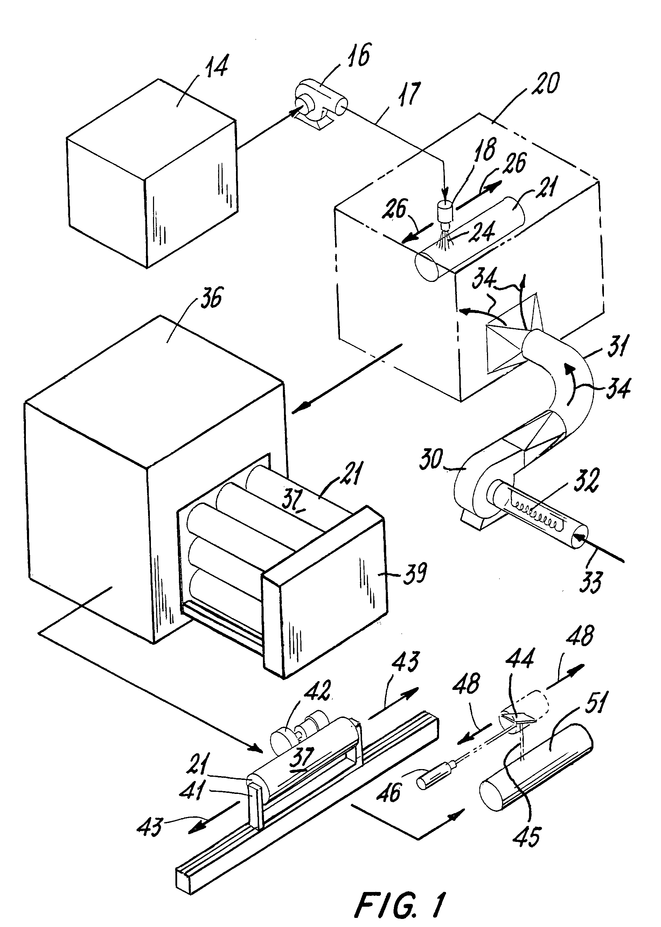

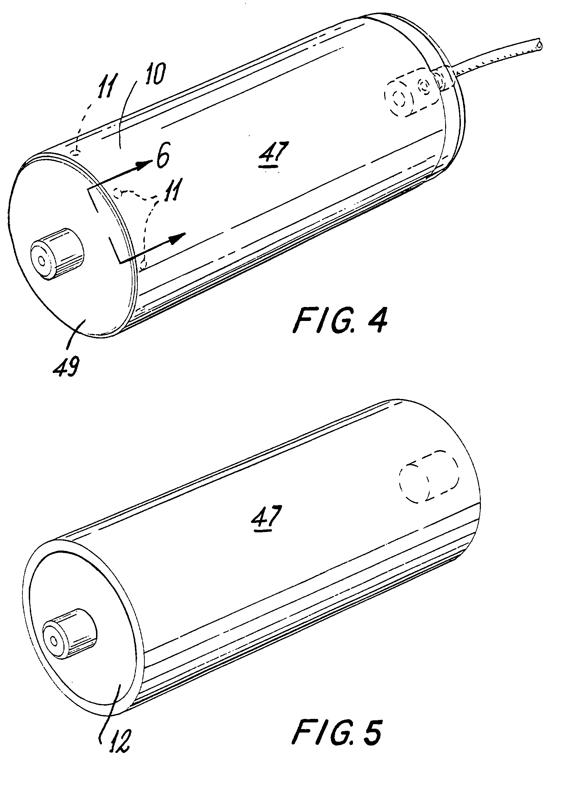

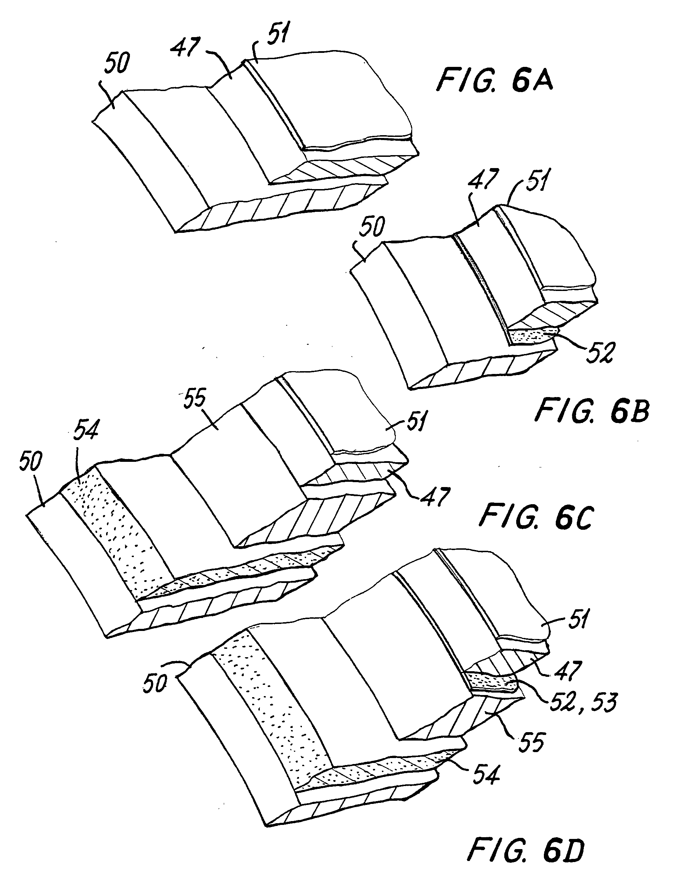

A presently preferred embodiment of a process for spraying a liquid photpolymer composition onto a cylindrical substrate to form a seamless, cylindrical printing sleeve 10 (Fig. 4) or printing cylinder 12 (Fig. 5) is illustrated schematically in Fig. 1. Any of a variety of cylindrical printing sleeves can be sprayed with a composition in accordance with the present invention. For instance, printing sleeves made from fiberglass, DUPONT® MYLAR® , tri-laminate KEVLAR® , nickel, copper, etc., can be used in the present invention. Moreover, sleeves with inner openings shaped as a cylinder (so-called parallel sleeves) and sleeves with inner openings having a slight conical shape (so-called tapered sleeves) may be spray coated with a photopolymer composition in accordance with the present invention.

Further, it should also be understood that the spray coating method of the present invention can also be utilized to form printing cylinders and thus can be used to coat steel cylinders, steel cylinders coated with nickel or copper, aluminum cylinders, aluminum cylinders coated with nickel or copper, rubber cylinders, etc.

As schematically shown in Fig. 1, the components of the photopolymer composition are first mixed together in a mixing apparatus, such as a reservoir that is generally designated by the numeral 14. Any of a variety of photopolymer materials can generally be utilized in the photopolymer composition. In one embodiment, monomers are grafted to photopolymers of relatively higher hardness (e.g., 50 to 70 Shore D) to form photopolymers of relatively lower hardness (60 to 70 Shore A). The photopolymer composition of the present invention desirably includes a photopolymer, a carrier solvent, grafted monomers, and optional components such as photoinitiators, photosensitizers and compressible microspheres or bubbles. The compressible microspheres or bubbles are used to form compressible photopolymer that is used to eliminate (or at least reduce) the need for deploying a compressible layer beneath the photopolymer layer of the sleeve or cylinder. Examples of these ingredients are set forth below.

### PHOTOPOLYMER

1. General: Polyamide-based, mixed acrylate and methacrylates-esters based, polyester-based, polyvinyl alcohol based, acrymilide, butadiene copolymer-based, polyurethane based, and the like
2. Preferred: Polyamide, acrymilide based
3. Example: BASF NYLOPRINT® S/83 Poly-amide, acrymilide based photopolymer available from BASF Charlotte, North Carolina
4. Other Examples: FHA-170 NYLOFLEX® mixed acrylate and methacrylates-esters based photopolymer, available from BASF Charlotte, North Carolina

### CARRIER SOLVENT

1. General: Alcohols, Water
2. Preferred: 80% (by volume) denatured ethanol or ethyl alcohol plus 20% (by volume) water
3. Specific: Ethanol, OPTISOL® made by DuPont, NutriClean® made by Savolite Inc. of Seattle, Washington, SOLVIT® and other alcohol-based solvents

### GRAFTED MONOMERS

1. General: monomers that may be useful for grafting to the photopolymer are Methyl methacrylate (MMA); ethyl methacrylate (EMA); butyl methacrylate (BMA); 2-ethylhexyl methacrylate; methyl acrylate (MA); ethyl acrylate (EA); butyl acrylate (BA); 2-ethylhexyl acrylate; 2-hydroxyethyl methacrylate (HEMA); 2-hydroxyethyl acrylate (HEA); methacrylic acid (MAA); acrylic acid (AA) ; esters of acrylic and methacrylic acids wherein the alcohol group contains from 1 to 18 carbon atoms; nitrites and amides of acrylic and methacrylic acids; glycidyl acrylate and methacrylate; itaconic acid (IA) and itaconic acid anhydride, itaconic acid half ester and itaconic imide; maleic acid and maleic acid anhydride, maleic acid half ester and maleimide; aminoethyl methacrylate; aminoethyl acrylate; t-butyl aminoethyl methacrylate; acrylamide; -t-octyl acrylamide; vinyl methyl ether; styrene (S); alpha-methyl styrene; vinyl acetate; vinyl chloride; butadiene (B); isoprene (I); vinyl pyrrolidone; t-butyl acrylate; 1,5-pentanediol diacrylate, N,N-diethylaminoethyl acrylate; ethylene glycol diacrylate; 1,4-butanediol diacrylate; diethylene glycol diacrylate; hexamethylene glycol diacrylate; 1,3-propanediol diacrylate; decamethylene glycol diacrylate, decamethylene glycol dimethacrylate, 1,4-cyclohexanediol diacrylate; 2,2-dimethylolpropane diacrylate; glycerol diacrylate; tripropylene glycol diacrylate, glycerol triacrylate, trimethylolpropane triacrylate, pentaerythritol triacrylate; polyoxyethylated trimethylolpropane triacrylate; and trimethacrylate and similar compounds as disclosed in U.S. Pat. No. 3,380,831, 2,2-di(p-hydroxyphenyl)-propane diacrylate; pentaerythritol tetraacrylate, 2,2-di-(p-hydroxyphenyl)-propane dimethacrylate; triethylene glycol diacrylate; polyoxyethyl-2,2-di-(p-hydroxyphenyl)-propane dimethacrylate; di-(3-methacryloxy-2-hydroxypropyl)ether of bisphenol-A, di-(2-methacryloxyethyl) ether of bisphenol-A, di-(3-acryloxy-2-hydroxypropyl) ether of bisphenol-A; di-(2-acryloxyethyl) ether of bisphenol-A; di-(3-methacryloxy-2-hydroxypropyl) ether of tetrachloro-bisphenol-A; di-(2-methacryloxyethyl) ether of tetrachloro-bisphenol-A; di-(3-methacryloxy-2-hydroxypropyl) ether of tetrabromo-bisphenol-A; di-(2-methacryloxyethyl) ether of tetrabromo-bisphenol-A; di-(3-methacryloxy-2-hydroxypropyl) ether of 1,4-butanediol; di-(3-methacryloxy-2-hydroxypropyl) ether of diphenolic acid; triethylene glycol dimethacrylate; polyoxypropyl one trimethylol propane triacrylate (462); ethylene glycol dimethacrylate; butylene glycol dimethacrylate; 1,3-propanediol dimethacrylate; 1,2,4-butanetriol trimethacrylate; 2,2,4-trimethyl-1,3-pentanediol dimethacrylate; pentaerythritol trimethacrylate; 1-phenyl ethylene-1,2-dimethacrylate; pentaerythritol tetramethacrylate; trimethylol propane trimethacrylate; 1,5-pentanediol dimethacrylate; diallyl fumarate; styrene; 1,4-benzenediol dimethacrylate; 1,4-diisopropenyl benzene; 1,3,5-triisopropenyl benzene; and the like.

### OPTIONAL COMPONENTS

1. viscosity modifying monomers may include ethoxylated trimethyl propane triacrlyate, polyethylene glycol diacrylates, or Bakelite phenoxy resin (Union Carbide), and the like.
2. 0.1 to 5% by weight Photoinitiators such as: benzoin, benzoin alkyl ethers, alpha-methylolbenzoin and its ethers, alpha-methylbenzoin, diketones and their derivatives, monoketals, and substituted quinones, such as anthraquinone.
3. 0.1 to 5% by weight Photosensitizers such as: potassium dichromate
4. Compressible microspheres or bubbles used to form compressible photopolymer layer:

Referring again to Fig. 1, the liquid photopolymer composition from the reservoir is provided to a pump 16 that can be used to transport the liquid photopolymer composition via pressure tubing 17 to a spray nozzle 18 disposed inside a spray chamber 20 that is schematically indicated by the cube defined by the chain-dashed lines and designated by the numeral 20.

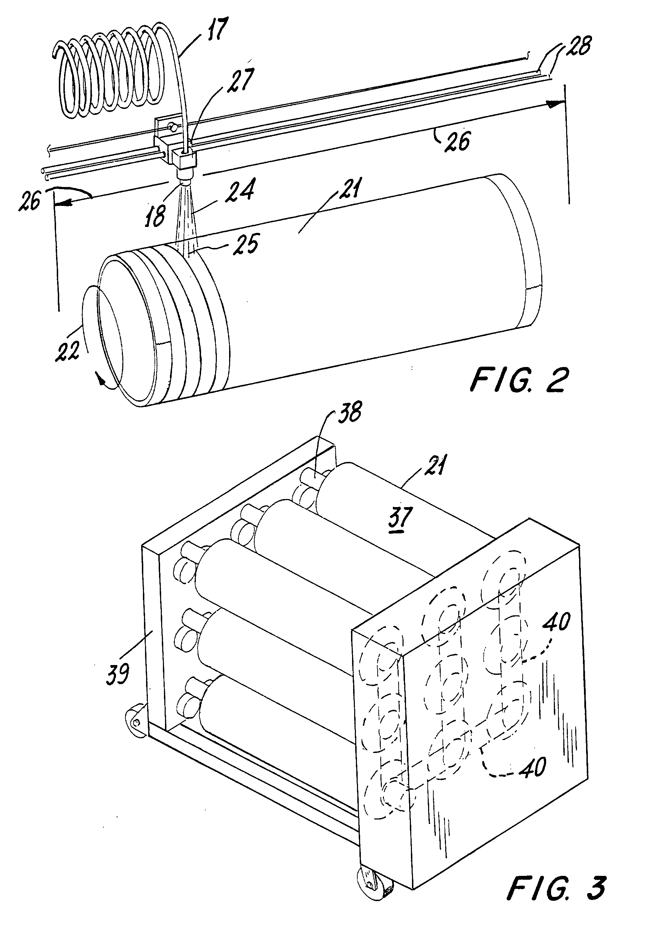

Inside the spray chamber 20, a cylindrical substrate 21 in the form of a cylinder or cylindrical sleeve can be mounted on a rotatable mandrel to rotate beneath the spray nozzle 18. Rotation of the cylindrical substrate 21 typically occurs at about 54 to 56 revolutions per minute (RPMs) but can run as high as 200 rpms and is schematically indicated in Fig. 2 by the arrow designated by the numeral 22.

As shown in Fig. 2 for example, the liquid photopolymer composition 24 can be pumped out of the nozzle 18 at a pressure within the range of about 45 to 65 pounds per square inch. The spray pattern 25 of the liquid photopolymer composition is directed along a radius of the cylindrical substrate 21. The distance between the exit orifices of the nozzle 18 and the exterior surface of the cylindrical substrate 21 is typically in the range of two to ten inches and desirably from two to four inches. When the liquid photopolymer composition 24 is sprayed onto the surface of the rotating cylindrical substrate 21, the exit orifices of the spray nozzle 18 typically will apply liquid photopolymer composition 24 to wet an area 25 of circular shape and about two inches in diameter. However, as schematically indicated by the double-ended arrow designated by the numeral 26 in Figs. 1 and 2, the nozzle 18 is mounted to a carriage 27 that moves on rails 28 linearly back and forth parallel to the exterior surface of cylindrical substrate 21. Moreover, if desired, the nozzle 18 can spray the composition onto the rotating cylindrical substrate 21 as the nozzle 18 moves back and forth in both directions. In other embodiments, however, the nozzle 18 can spray the composition only while the carriage is moving in one direction. Moreover, it is contemplated that the nozzle 18 can be kept stationary while a carriage is provided to move the cylindrical substrate to and fro. Alternatively, it is contemplated that more than one nozzle 18 can be used and that one or more nozzles 18 and the substrate 21 can be moving at the same time using various motors and relays under control of a computer if desired.

In accordance with the present invention, any of a variety of spraying nozzles 18 known in the art can be used. It should be understood, however, that in some embodiments, an adhesive can first be applied (also as by spraying for example) to facilitate attachment of the liquid photopolymer composition 24 to the cylindrical substrate 21.

In addition, in some embodiments described below, prior to spraying the photopolymer composition 24 onto the cylindrical substrate 21, a compressible layer can be applied to the cylindrical substrate in order to minimize "dot gain." This disposes a compressible layer beneath the seamless, cylindrical photopolymer layer. Suitable compressible layers can include, but are not limited to, a compressible foam layer, an aerated (i.e., containing spheres or bubbles) photopolymer composition, and the like.

Referring again to Fig. 1, while the liquid photopolymer composition 24 is being sprayed onto the cylindrical substrate 21, it is typically desired that any remaining solvent be removed therefrom. For example, as shown, a drying mechanism can be used to heat the rotating cylindrical substrate 21 while the photopolymer is being sprayed onto substrate 21. In one embodiment, the drying mechanism can use hot air to heat the interior of the spray chamber 20 containing the cylindrical substrate 21 to a temperature of at least about 100°F. An air blower 30 can be provided and have an outlet connected via suitable ducting 31 to spray chamber 20 to blow air into the interior of the spray chamber 20. The air blower 30 can be provided with a heating element 32 for heating the air that enters the air blower 30 before the air is blown into the spray chamber 20. In this way, the temperature inside the spray chamber 20 can be controlled, and this temperature is desirably maintained at no less than about 100°F. The arrow designated by the numeral 33 represents ambient air that is heated by the heating element 32 of the air blower 30. The arrows designated by the numeral 34 represent the heated air that is blown into the interior of the spray chamber 20 by the blower 30.

In general, a variety of parameters, such as the number of nozzle passes, wet volume of the liquid photopolymer composition applied, viscosity of the liquid photopolymer composition, the pressure of the liquid photopolymer composition during application, rotation rate of the cylindrical substrate, nozzle distance from the surface of the cylindrical substrate, etc., can be varied to control the resulting thickness of the cylindrical photopolymer layer deposited. For instance, in one embodiment, 250 nozzle passes and a wet volume of approximately 0.8 gallons to about one (1) gallon can be used to produce a coating having a thickness of approximately 0.078 inches. If desired, the viscosity of the photopolymer composition 24 can be varied to correspond to the rotation rate of the cylindrical substrate 21.

After application of the photopolymer composition 24, the resulting sleeve or cylinder covered with photopolymer can also be transferred into a vertical or horizontal oven 36 for further evaporation of the solvent. As shown in Fig. 3 for example, each cylindrical substrate 21 to which has been applied an unfinished, seamless, cylindrical layer 37 of photopolymer composition is mounted on a mandrel 38 that is rotatably carried by a dolly 39. The dolly 39 is mobile so that it can be wheeled into and out of the oven 36. Each mandrel 38 is rotated by driven belts 40 or chains 40 in order to rotate the cylindrical substrates 21 during their stay within the oven 36 in order to promote even drying and uniformity of the thickness of the unfinished photopolymer layer 37.

After being dried, the exterior surface of each unfinished, seamless, cylindrical layer 37 of photopolymer composition is ready to receive a carbon black film prior to being digitally imaged and processed to form the printing surface of a flexographic printing sleeve or cylinder. It has been found that the exterior surface of the photopolymer layer produced according to the present invention does not need to be ground/polished before it can receive a carbon black film prior to being digitally imaged and processed to form the printing surface of a flexographic printing sleeve or cylinder. This is a significant advantage over prior processes and sleeves/cylinders produced according to such prior processes. Thus, in most instances, a carbon black mask layer 51 can be applied directly to the surface of unfinished cylindrical layer 37 of photopolymer without any grinding or polishing preparation. Accordingly, in such instances, it is not necessary to use the platform 41 and polisher 42 shown in Fig. 1.

However, in some instances it might be desired to subject the surface of the unfinished photopolymer layer 37 to being generally ground and/or polished. A variety of mechanisms, such as grinders or belt polishers, can be used to accomplish this step. As shown in Fig. 1, the cylindrical substrate 21 can be mounted on a platform 41 that rotates the cylindrical substrate 21 while translating the cylindrical substrate 21 back and forth against the exterior surface of a polisher 42. The linear translation of platform 41 is schematically indicated by the arrows designated by the numeral 43 in Fig. 1. Alternatively, the polisher 42 can move linearly while the platform 41 that rotatably carries the substrate 21 remains stationary, or both the polisher and the platform 41 can move relative to one another.

Once the photopolymer composition layer of the sleeve 10 or cylinder 12 is ground and polished, the finished, seamless cylindrical layer of photopolymer composition can then be further processed, treated or finished as desired, depending on the final application. For instance, an anti-oxidation layer can be applied. This can take the form of a thin layer of carbon black that is deposited to a thickness in the range of 10 to 15 microns by any conventional process. Alternatively, the seamless, cylindrical layer of photopolymer composition can then be imaged according to methods well known in the art. For instance, the imaging of the photopolymer composition layer can be processed with conventional negatives, digital imaging of black masks, direct digital layering, and the like.

In particular, in one embodiment, a thin layer (e.g., 10 to 15 microns) of a mask formed of carbon black can first be applied to the polished exterior surface of the cylindrical photopolymer layer. Thereafter, a YAG laser can be utilized to produce an image on the photopolymer composition by removing (ablating) the carbon black mask where the image is to be formed. For instance, as shown in Fig. 1, laser beams 45 generated from a computer-controlled laser 46 into can be directed via one or more linearly translating mirrors 44 to ablate the mask 51 in accordance with the images to be formed in the finished, seamless cylindrical photopolymer layer 47 (not shown in Fig. 1). The linear translation of mirror 44 is schematically indicated by the arrows designated by the numeral 48 in Fig. 1 and can be controlled by a computer (not shown). After ablating the mask 51 with the laser 46 to form the desired image in the ablated portions of the mask 51, the sleeve is bathed in UV actinic light to polymerize (harden) the portions of the photopolymer layer that are no longer covered by the black mask 51. This UV light bath process typically takes ten to fifteen minutes depending upon the UV light set up. Then the portions of the layer of photopolymer that were not exposed to the laser and the UV light bath (because they remained beneath the black mask 51) can then be washed out by utilizing a suitable solvent treatment, such as 80% (by volume) denatured ethanol or ethyl alcohol plus 20% (by volume) water. The resulting imaged cylindrical photopolymer layer can then be dried, finished, and used in the desired printing application.

Various embodiments of printing sleeves and/or solid cylinders formed with seamless, cylindrical photopolymer layers in accordance with the above-described process are illustrated in Figs. 4 through 6E. Referring to Fig. 4, for example, a printing sleeve 10 containing a finished, seamless, cylindrical layer 47 of photopolymer composition formed according to the present invention is illustrated as being mounted on a vacuum mandrel 49, which includes a plurality of air holes 11 (shown in dashed line) for air mounting of the sleeve 10. Moreover, referring to Fig. 5, a steel or aluminum cylinder 12 containing a finished, seamless, cylindrical layer 47 of photopolymer composition in accordance with the present invention is also illustrated.

In general, referring to Figs. 6A through 6E in which the proportions of the various layers have been exaggerated in order to facilitate explanation of the invention, various embodiments of the sleeve and cylinder of Figs. 4 and 5 are also schematically illustrated. For ease of illustration and to avoid unnecessary duplication, the underlying core will be deemed part of a sleeve rather than a cylinder.

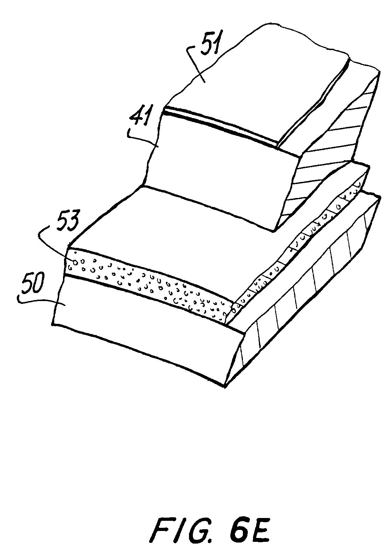

For example, referring to Figs. 6A, 6B and 6E, one embodiment of a printing sleeve or cylinder that includes a seamless, cylindrical photopolymer layer 47 having a thickness of about 0.040 inches and formed in accordance with the present invention is schematically illustrated. As shown in Fig. 6A, the printing sleeve or cylinder includes a first layer 47 of a photopolymer composition formed in accordance with the present invention and having a thickness of about 0.040 inches disposed atop and directly onto the exterior surface of the core layer 50 of a sleeve or cylinder. A black mask layer 51 having a thickness between about 10 to 15 microns is applied on top of the finished exterior surface of the seamless, cylindrical layer 47 of photopolymer composition. Moreover, as shown schematically in Fig. 6B, the printing sleeve or cylinder can also include a first adhesive layer 52 formed in accordance with the present invention and having a thickness of about 0.005 inches located between the bottom of the photopolymer composition layer 47 and the exterior surface of the core 50 of the sleeve or cylinder. In lieu of an adhesive layer, the printing sleeve or cylinder can include a compressible layer 53, such as schematically shown in Fig. 6E, having a thickness of about 0.020 inches and disposed between the bottom of the seamless, cylindrical layer 47 of photopolymer composition and the exterior surface of the core 50 of the sleeve or cylinder.

Referring to Figs. 6C and 6D, additional embodiments of printing sleeves or cylinders of the present invention are schematically illustrated. As shown in Fig. 6C, the printing sleeve or cylinder includes an inner core 50 of wound fiberglass having a thickness of about 0.040 inches, a second layer 54 of polyurethane foam having a thickness of about 0.040 inches, a third layer 55 of rigid polyurethane having a thickness that can be varied depending on the desired repeat but typically having a thickness of at least about 0.080 inches. A photopolymer composition layer 47 formed in accordance with the present invention and having a thickness of about 0.040 inches is then applied to the exterior surface of the third layer 55 of rigid polyurethane. In an alternative embodiment as shown schematically in Fig.6D, an adhesive layer 52 or compressible layer 53 can also be applied between the third layer 55 of rigid polyurethane mentioned above and the seamless, cylindrical layer 47 of photopolymer composition.

### EXAMPLE

The ability of a liquid photopolymer composition to be sprayed onto a seamless printing sleeve was demonstrated. A liquid photopolymer composition was first formed according to the present invention to include 45.44% by weight ethanol, 30.2% by weight photopolymer, 13% by weight grafted monomers and 11.36% by weight other additives including monomers, photosensitizers and photoinitiators. To form the photopolymer composition, a sheet measuring 25 inches by 32 inches by 0.038 inches of BASF NYLOPRINT S/83 photopolymer, a polyamide, acrylimide-based photopolymer of about 50 to 60 Shore D hardness, was initially obtained from BASF. As known, these sheets are provided on one side with a sealed steel backing measuring 0.010 inches thick and are imbued with photosensitizers such as between 0.1 to 0.5% by weight potassium dichromate and 0.1 to 5.0% by weight photoinitiators such as one or more selected from the list provided above. A carrier solvent such as 80% (by volume) denatured ethanol or ethyl alcohol plus 20% (by volume) water was then applied to the sheet to dissolve the photopolymer. Thereafter, grafted monomers would be added in order to reduce the Shore hardness, and other additives such as monomers (viscosity modifying) were mixed with the alcohol-based photopolymer composition. The viscosity of the resulting photopolymer composition of the present invention was believed in the range of about 25 to about 35 centipoise.

The liquid photopolymer composition formed above was then dispensed into a spray nozzle (i.e., high volume, low pressure spray nozzle such as PAINTER'S CHOICE PROFESSIONAL® spray gun Model No. FR-103 made in Taiwan) and sprayed onto a cylindrical core of wound fiberglass having an outside diameter of 6.196 inches, an inside diameter of 6.276 inches, and a length of 24 inches. The core was rotated at a rate of about 59 rpm during the spraying application of the liquid photopolymer composition. The nozzle was held at a distance of about 8 inches to about 10 inches during spraying. Moreover, the photopolymer composition was sprayed onto the exterior surface of the sleeve beginning at a pressure of about 55 pounds per square inch until about two thirds of the desired thickness of 0.078 inches of photopolymer layer was applied. Thereafter, the photopolymer composition was sprayed onto the exterior surface of the sleeve at a pressure of about 45 pounds per square inch until the last one third of the desired thickness of 0.078 inches of photopolymer layer has been applied.

During the spraying, the nozzle passed from one end of the core to the other end of the core 250 times, and approximately 0.8 gallons of the liquid photopolymer composition was sprayed onto the core. The resulting thickness of the photopolymer composition that had been applied to the core was about 0.078 inches. The resulting core was rotated for 24 hours in an oven maintained at a temperature of about 100 degrees Fahrenheit. The exterior surface of the seamless, cylindrical photopolymer layer was polished and made ready for subsequent processing to form a printing image thereon. The resulting printing sleeve had a durometer reading of 65 to 70 Shore A. While the resulting printing sleeve has not been tested, it is believed likely to have a useful life of several million impressions. It is also believed likely to lend itself to high quality flexographic printing comparable to gravure and wet offset process colors with excellent ink transfer and resistance to ethyl acetate, methyl ethyl ketone and other alcohols found in solvent-based and water-based flexographic inks.

Digital imaging is becoming more prevalent in the industry. The digital imaging of a sleeve or cylinder that is pre-coated with a continuous, seamless cylindrical photopolymer layer according to the present invention improves the efficiency of the digital imaging process relative to the traditional imaging process that involves having to attach a virgin, non-cured photopolymer plate with double sided tape and then having to apply a mask. Additionally, by having a continuous photopolymer coating that adheres well to the underlying sleeve or cylinder as in the present invention, there is no possibility of the photopolymer plate or sticky back lifting and the photopolymer plate becoming unattached.

While a preferred embodiment of the invention has been described using specific terms, such description is for illustrative purposes only, and it is to be understood that changes and variations may be made without departing from the spirit or scope of the following claims.

## Claims

1. A liquid photopolymer composition having a predefined viscosity in the range of 25 to 35 centipoises such that it can be sprayed onto a rotating cylindrical core to form a seamless, cylindrical surface in the range of 60 to 70 Shore A hardness suitable for imaging the printing matrices of a flexographic printing sleeve, the composition comprising:
a photopolymer of Shore D hardness in the range of 50 to 70;
a carrier solvent;
a grafted monomer to reduce the hardness to a range of 60 to 70 Shore A; and
at least one of the following materials:
monomers, photoinitiators, and photosensitizers.

2. A composition as claimed in claim 1, **characterised by** comprising compressible bubbles or microspheres.

3. A composition as claimed in claim 1, **characterised in that** the photopolymer is selected from the following photopolymers: polyamide-based, mixed acrylate and merthacrylate-ester based, polyester-based, polyvinylalcohol-based, acrymilide, butadiene copolymer-based, polyurethane-based and the like.

4. A composition as claimed in claim 1, **characterised in that** the carrier solvent comprises alcohol and water.

5. A composition as claimed in claim 4, **characterised in that** the carrier solvent preferably comprises 80 vol% of denatured ethyl alcohol or ethanol plus 20 vol% of water.

6. A composition as claimed in claim 1, **characterised by** comprising a monomer chosen from: methyl methacrylate (MMA) ; ethyl methacrylate (EMA); butyl methacrylate (BMA); 2-ethylhexyl methacrylate; methyl acrylate (MA); ethyl acrylate (EA); butyl acrylate (BA); 2-ethylhexyl acrylate; 2-hydroxyethyl methacrylate (HEMA); 2-hydroxyethyl acrylate (HEA); methacrylic acid (MAA) ; acrylic acid (AA); esters of acrylic and methacrylic acids wherein the alcohol group contains from 1 to 18 carbon atoms; nitrites and amides of acrylic and methacrylic acids; glycidyl acrylate and methacrylate; itaconic acid (IA) and itaconic acid anhydride, itaconic acid half ester and itaconic imide; maleic acid and maleic acid anhydride; maleic acid half ester and maleimide; aminoethyl methacrylate; aminoethyl acrylate; t-butyl aminoethyl methacrylate; acrylamide; -t-octyl acrylamide; vinyl methyl ether; styrene (S); alpha-methyl styrene; vinyl acetate; vinyl chloride; butadiene (B); isoprene (I); vinyl pyrrolidone; t-butyl acrylate; 1,5-pentanediol diacrylate; N,N-diethylaminoethyl acrylate; ethylene glycol diacrylate; 1,4-butanediol diacrylate; diethylene glycol diacrylate; hexamethylene glycol diacrylate; 1,3-propanediol diacrylate; decamethylene glycol diacrylate; decamethylene glycol dimethacrylate; 1,4-cyclohexanediol diacrylate; 2,2-dimethylolpropane diacrylate; 2,2-dimethylolpropane diacrylate; glycerol diacrylate; tripropylene glycol diacrylate; glycerol triacrylate; tripropylene glycol diacrylate; glycerol triacrylate; trimethylolpropane triacrylate; pentaerythritol triacrylate; polyoxyethylated trimethylolpropane triacrylate; trimethacrylate and similar compounds; 2,2-di(p-hydroxyphenyl)-propane diacrylate; pentaerythritol tetraacrylate; 2,2-di(p-hydroxyphenyl)-propane dimethacrylate; triethylene glycol diacrylate; polyoxyethyl-2,2-di(p-hydroxyphenyl)-propane dimethacrylate; di-(3-methacryloxy-2-hydroxypropyl) ether of bisphenol-A; di-(2-methacryloxy-2-hydroxypropyl) ether of bisphenol-A; di-(3-acryloxy-2-hydroxypropyl)ether of bisphenol-A; di-(2-acryloxy-2-hydroxypropyl)ether of bisphenol-A; di-(3-methacryloxy-2-hydroxypropyl) ether of tetrachloro-bisphenol-A; di-(2-methacryloxy-2-hydroxypropyl) ether of tetrachloro-bisphenol-A; di-(3-methacryloxy-2-hydroxypropyl) ether of tetrabromo-bisphenol-A; di-(2-methacryloxy-2-hydroxypropyl) ether of tetrabromo-bisphenol-A; di-(3-methacryloxy-2-hydroxypropyl) ether of 1,4-butanediol; di-(3-methacryloxy-2-hydroxypropyl) ether of diphenolic acid; triethylene glycol dimethacrylate; polyoxypropyl one trimethylol propane triacetylate (462); ethylene glycol dimethacrylate; butylene glycol dimethacrylate; 1,3-propanediol dimethacrylate; 1,2,4-butanetriol dimethacrylate; 2,2,4-trimethyl-1,3-pentanediol dimethacrylate; pentaerythritol trimethacrylate; 1-phenyl ethylene-1,2- dimethacrylate; pentaerythritol tetramethacrylate; trimethylol propane trimethacrylate; 1,5-pentanediol dimethacrylate; diallyl fumarate; styrene; 1,4-benzenediol dimethacrylate; 1,4-diisopropenyl benzene; 1,3,5-triisopropenyl benzene; and the like.

7. A composition as claimed in claim 6, **characterised by** comprising viscosity modifying monomers such as ethoxylated trimethyl propane triacrylate, polyethylene glycol triacrylates, or Bakelite phenoxy resin (Union Carbide), and the like.

8. A composition as claimed in claim 1, **characterised in that** the photoinitiators comprise benzoin, benzoin alkyl ethers, alpha-methylolbenzoin and its ethers, alpha-methylbenzoin, diketones and their derivatives, monoketals, and substituted quinones, such as anthraquinones.

9. A composition as claimed in claim 1, **characterised in that** the photoinitiators are present in a quantity from 0.1 to 5% by weight.

10. A composition as claimed in claim 1, **characterised in that** the photosensitizers are present in a quantity from 0.1 to 5% by weight.

11. A composition as claimed in claim 1, **characterised in that** the photosensitizers comprise potassium dichromate.

12. A method of making a sprayable liquid photopolymer composition (24) having a viscosity in the range of 25 to 35 centipoise such that it can be sprayed onto a rotating cylindrical core (21) to form a seamless, cylindrical surface in the range of 60 to 70 Shore A hardness suitable for imaging the printing matrices of a flexographic printing sleeve, the method comprising:
dissolving, in a carrier solvent, a photopolymer sheet of Shore D hardness in the range of 50 to 70 to form a precursor photopolymer composition;
adding at least one grafted monomer to said precursor photopolymer composition to form a grafted photopolymer composition; and
adding to said grafted photopolymer composition at least one of the following materials: monomers, photoinitiators, and photosensitizers.

13. A method as claimed in claim 12, **characterised in that** 80% by volume of denatured ethanol or of ethyl alcohol plus 20% by volume of water are used as the carrier solvent.

14. A method as claimed in claim 12, **characterised in that** a quantity from 0.1 to 5% by weight of photoinitiators is introduced into the grafted photopolymer composition.

15. A method as claimed in claim 12, **characterised in that** a quantity from 0.1 to 5% by weight of photosensitizers is introduced into the grafted photopolymer composition.

16. A method as claimed in claim 12, **characterised by** inserting, into the grafted photopolymer composition, elements able to form a compressible polymer layer, these elements being bubbles or microspheres.

17. A method as claimed in claim 12, **characterised by** inserting, into the grafted photopolymer composition, viscosity modifying monomers.

18. A method of forming a seamless photopolymer layer with a hardness in the range of 60 to 70 Shore A for a flexographic printing sleeve or cylinder, the method comprising the steps of:
rotating a cylindrical surface (21);
spraying a photopolymer composition (24) having a certain viscosity onto said rotating surface to produce a seamless and continuous layer of photopolymer;
drying said photopolymer layer; and
applying a thin layer of carbon black to the surface of said photopolymer layer.

19. A method as claimed in claim 18, further comprising the steps of:
ablating said carbon black layer to produce a desired image therein;
exposing said ablated layer of photopolymer to actinic UV radiation; and
washing out said photopolymer layer to form the printing matrices of a flexographic printing sleeve.

20. A method as claimed in claim 18, **characterised by** comprising the movement along a rectilinear path of one or more of said cylindrical core (21) and at least one nozzle (18) from which the liquid composition 24 emerges.

21. A method as claimed in claim 18, **characterised by** comprising the application of an adhesive onto the cylindrical core (21) before depositing onto this latter the liquid photopolymer composition (24).

22. A method as claimed in claim 18, **characterised by** comprising the application of at least one compressible layer onto the cylindrical core (21) before depositing onto this latter the liquid photopolymer composition (24).

23. A method as claimed in claim 22, **characterised in that** the compressible layer comprises a compressible foam, an aerated photopolymer composition or the like.

24. A method as claimed in claim 18, **characterised by** comprising the removal of the solvent carrying the liquid composition (21) during the spray deposition of this latter onto the cylindrical core (21).

25. A method as claimed in claim 22, **characterised in that** the solvent is removed by heating the cylindrical core (21) during the deposition of the photopolymer composition (24).

26. A method as claimed in claim 22, **characterised in that** the cylindrical core is heated by heating the environment in which the deposition of the liquid photopolymer composition (24) thereon takes place.

27. A method as claimed in claim 25, **characterised in that** the solvent is removed by heating the cylindrical core (21) already coated with the photopolymer composition in an oven (36).

28. A method as claimed in claim 27, **characterised in that** the cylindrical core (24) is rotated while in the oven (36).

29. A method as claimed in claim 18, **characterised in that** after the drying of the photopolymer layer, its surface is machined before applying the carbon black layer, this machining comprising grinding and/or polishing.

30. A method as claimed in claim 18, **characterised in that** the photopolymer composition (24) has a viscosity from 25 to 35 centipoise.

31. A device for use in flexographic printing, comprising:
an elongated core member (50) having a generally cylindrical surface, said core member (50) having a central rotational axis and being formed of diametrically expandable, high rigidity material, said core member having a cylindrical outer surface;
a seamless photopolymer layer (47) having an outer surface configured to be imaged to form printing matrices (51), said seamless photopolymer layer (47) having an inner surface disposed against said outer surface of said compressible layer, **characterised in that** said seamless photopolymer layer has a Shore A hardness in the range of 60 to 70.

32. A device as claimed in claim 31, **characterised by** comprising a compressible cylindrical layer (53) for mechanically absorbing the radial expansion of said core member (50), said compressible layer (53) having an inner surface disposed against said cylindrical outer surface of said core member, said compressible layer having an outer surface disposed on the other side with respect to said core member.

33. A device as claimed in claim 31, **characterised by** being a sleeve (10) to be mounted on a rotary mandrel (49), said sleeve (10) comprising an inner aperture for the aforesaid mounting.

34. A device as claimed in claim 31, **characterised in that** the inner aperture of the sleeve (10) is of cylindrical shape, the sleeve being of parallel type.

35. A device as claimed in claim 33, **characterised in that** the inner aperture of the sleeve (10) is of conical shape, the sleeve (10) being tapered.

36. A device as claimed in claim 31, **characterised in that** the core member is of composite material such as glass fibre, carbon fibre, aramid fibres or the like.

37. A device as claimed in claim 31, **characterised in that** the core member is of metal, such as nickel, copper or the like.

38. A device as claimed in claim 31, **characterised by** comprising a plurality of layers (54, 55) of polyurethane material between the core member (50) and the photopolymer layer (47).

39. A device as claimed in claim 31, **characterised by** being a printing cylinder.
